# EUROPEAN PATENT APPLICATION

(11) **EP 4 814 959 A1**
(43) Date of publication of application: **30.09.2026**
(21) Application number: 26167130.9
(22) Date of filing: 24.03.2026
(51) Int. Cl.: G11C 5/06, G11C 11/4093, G11C 5/02, G11C 5/04, G11C 7/10

(54) **MULTIPLE DDR SUBSYSTEMS WITH SINGLE BEACHFRONT USING CHAINED PHYS**

(30) Priority: 24.03.2025 US 202519088138
(71) Applicant: Google LLC, Mountain View, CA 94043 (US)
(72) Inventor: Padeh, Yaniv, 3508409 Haifa (IL); Malka, Nir, 3508409 Haifa (IL)
(74) Representative: Betten & Resch

(57) **Abstract**

A memory subsystem in a compute device includes a number of memory controllers in combination with one or more physical layers (PHY). A processor of the device adjacent to the memory controllers communicates processing commands for memory requests with the MCs that manages the reading and writing of data from memory via the PHY. The width of the PHY defines the amount of space required by the memory subsystem along an edge of the processor. A number PHY are accommodated within the space of one PHY beachfront through stacking PHY with respect to the memory controllers. Tunnels are provided across the PHY passing between I/O pads of the PHY that connect distant PHY to the memory controllers. The compute device can utilize larger amounts of memory supporting multiple PHY in the space of one memory subsystem.

## Description

### BACKGROUND

The double data rate (DDR) subsystem is a component of a System on Chip (SoC) device. The DDR subsystem can be implemented an as application specific integrated circuit (ASIC) chip providing a DDR interface for high speed communication with external static dynamic random access memory (SDRAM). This type of chip is commonly found in applications requiring intensive data processing and data transfer including but not limited to central processing units (CPU), graphics processing units (GPU), tensor processing units (TPU), and the like.

Due to the structure of the input/output (I/O) pads that provide physical connections between the DDR subsystem and the external DDR memory modules. The I/O pads consume significant dimensions relative the DDR subsystem. Further, the I/O pads must be placed adjacent to one another to share signals and clocks. The requirements established by the I/O pads create the need for a long or wide form factor and beachfront for the DDR subsystem.

The long or wide form factor of the DDR subsystem establishes a limit on the total number of DDR subsystems that can be located on one chip. As the compute beachfront is limited in size, the number of DDR modules that can be integrated become constrained. As a result, overall performance of the chip is affected.

### BRIEF SUMMARY

A compute device includes a compute part, a plurality of memory channels in communication with the compute part. Each memory channel has a memory subsystems that includes a memory controller (MC) in communication with the compute part and a physical layer (PHY) associated with the MC of the memory channel. To accommodate a larger number of PHY layers a number of PHY are stacked widthwise contained within a beachfront associated with the plurality of PHY layers that takes up a space of a single PHY at an edge of the compute part. The compute device can be implemented as a system on chip (SoC) device. Each memory channel may be connected to an external dynamic random access memory module (DRAM) in communication with the PHY layer of a corresponding memory channel. PHY layers that are stacked include tunnels extending across the PHY layers. MCs for a group of stacked PHY are positioned adjacent to the compute part to minimize latency due to communication distance. Tunnels that pass across the PHY are provided to allow the MC for a given PHY that is distant to the MCs to communicate with its corresponding PHY. A first PHY in the linked group is adjacent to the MCs opposite the compute part. The MCs corresponding to the first PHY is directly connected to the first PHY. The tunnels are placed between an input pad and an output pad of the PHY. The tunnels may interconnect to extend across multiple PHYs between the MC and the MC's corresponding PHY. Each PHY may be associated with a pair of MCs associated with each PHY. The number of stacked PHYs can be greater than two where each of the stacked PHYs corresponds to a pair of MCs of the plurality of MCs. A tunnel corresponding to each PHY connects the PHY to the PHY's corresponding pair of MCs.

According to a method for providing dual data rate (DDR) memory to a compute device, a plurality of memory controllers (MCs) are placed adjacent to a compute part of the device. A first DDR PHY is disposed adjacent to the side of the plurality of MCs opposite the compute part. At least one additional DDR PHY is placed next to the first DDR PHY opposite the plurality of MCs. The at least one additional DDR PHY is connected to the plurality of MCs via a tunnel extending across the first DDR PHY and the at least one additional DDR PHY. The tunnel extends across the DDR PHY between a set of input pads and a set of output pads of the DDR PHY. Within the number of MCs, a pair of MCs corresponds to each PHY of the first DDR PHY and the at least one additional DDR PHY. Instructions from a pair of MCs provided to the corresponding DDR PHY through a tunnel extending from the pair of MCs to the corresponding DDR PHY. For each DDR PHY, a pair of tunnels include a first tunnel extending from the DDR PHY to a first MC of the corresponding pair of MCs, and a second tunnel extending from the DDR PHY to a second MC of the corresponding pair of MCs. The first DDR PHY positioned closest to the MCs is directly connected to its corresponding pair of MCs. The tunnels can be disposed in a gap between the input/output pads of the first DDR PHY and the at least one additional DDR PHY to provide a communication path to any of the DDR PHY layers. The number of PHY that can be stacked beside each other can be scaled to a number n DDR PHY. The compute part of the compute device can be a central processing unit (CPU) and a graphics processing unit (GPU) or other processing component. The compute device can be implemented as a system on chip (SoC).

According to an aspect, there is provided a memory subsystem in a compute device includes a number of memory controllers in combination with one or more physical layers (PHY). A processor of the device adjacent to the memory controllers communicates processing commands for memory requests with the MCs that manages the reading and writing of data from memory via the PHY. The width of the PHY defines the amount of space required by the memory subsystem along an edge of the processor. A number PHY are accommodated within the space of one PHY beachfront through stacking PHY with respect to the memory controllers. Tunnels are provided across the PHY passing between I/O pads of the PHY that connect distant PHY to the memory controllers. The compute device can utilize larger amounts of memory supporting multiple PHY in the space of one memory subsystem.

### BRIEF DESCRIPTION OF THE DRAWINGS

FIG. 1 is a plan view of a compute device according to aspects of the described technology.
FIG. 2 is a plan view of a compute device including DDR subsystems according to aspects of the described technology.
FIG. 3 is a plan view of a DDR memory subsystem according to aspects of the described technology.
FIG. 4 is a plan view of a chained number of DDR memory subsystems according to aspects of the described technology.
FIG. 5 is a process flow diagram for providing a compute device with chained DDR memory subsystems according to the described technology.
FIG. 6 is a block diagram of an example system according to aspects of the described technology.

### DETAILED DESCRIPTION

The technology is generally directed to managing external memory modules in a SoC compute device using memory subsystems. The DDR subsystem is a part of the SoC such as an application specific integrated circuit (ASIC) chip that incorporates a DDR interface for high speed communication with external SDRAM memory. This type of chip is commonly found in applications that require intensive data processing and data transfer, such as CPU, GPU, etc. The DDR memory subsystem can be viewed having two major components. First, is the DDR memory controller (MC). The MC manages communications between the compute part or processing component in the SoC and the DDR memory subsystem, including data transfer, timing and error correction. Second is the physical layer (PHY). The PHY supports the JEDEC open standard's specified steps to synchronize the memory timing between the controller and the SDRAM. It provides the electrical interface to the DDR memory, ensuring signal integrity and compliance with DDR specifications.

The data path flow proceeds from the compute part to the memory controller and onward to the DDR PHY, and in the same way for the other DDR memory subsystems extending from the compute part. A major component of the DDR PHY is the input/output (I/O) pads. I/O pads form the physical connections between the PHY and the external DDR memory modules, such as single inline memory modules (SIMMs). They are designed to handle the high frequency signals and ensure reliable data transmissions.

These pads have significant dimensions in relation to the total DDR PHY size and the DDR subsystem. The IO pads need to be abutted to each other in order to share signals and clocks. This structure of the IO pads defines the DDR dimensions and creates a long or wide form factor and beachfront for the DDR subsystem that limits the number of DDR subsystems that can be located on one chip. The compute part has discrete dimensions, and the connections to the DDR controllers need to be as short as possible in order to minimize latency of the data path. Furthermore, the SoC incorporates several subsystems for connectivity and communication, such as PCIe, PLL and GPIO, which must be situated in proximity to the compute components to minimize latency. As a result, the compute beachfront is limited in size and the number of DDR modules that can be integrated is restricted. Limiting the amount of available memory affects the overall performance of the chip. For example, a compute part with a rectangular form factor and a DDR subsystem with a height or width of half the computer subsystem limits the total number of DDR subsystems to four, two on each side of the computer part.

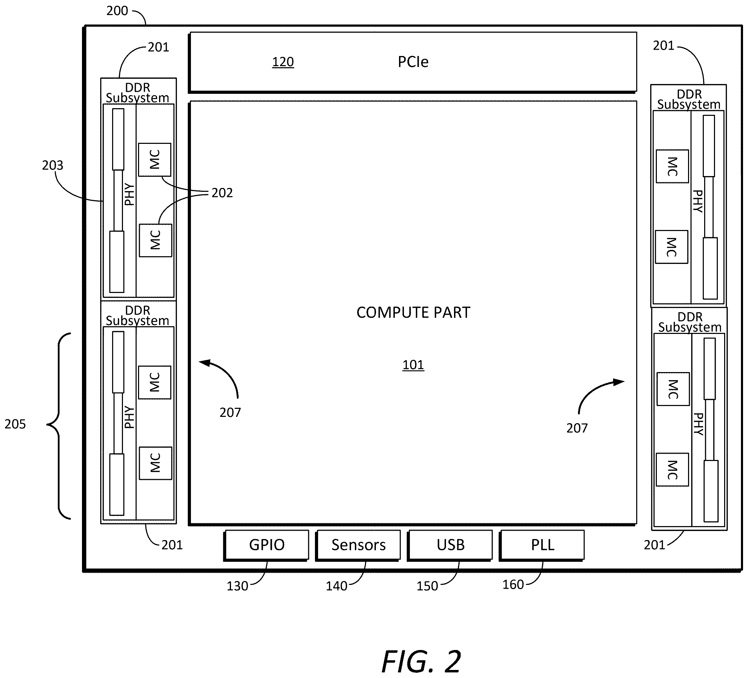

FIG. 2 is a plan view of a compute device 200 having a plurality of DDR memory subsystems 201 according to aspects of the described technology. Processing for the compute device 200 occurs in the compute part 101. The compute part 101 is in communication with many components of the compute device 200 including a peripheral component interconnect express (PCIe) interface 120 that interconnects components in the compute device 200. In addition, other system components and systems are in communication with the compute part 101. These may include general purpose input/output (GPIO) 130, sensors 140, universal serial bus (USB) 150 and system and phase lock loops (PLL) 160 for controlling the synchronization of signals in high frequency applications. To minimize latency, these system components compete with DDR memory subsystems 201 for space proximal to the compute part 101. This results in a constraint limiting the number of DDR memory subsystems that can be accommodated in the compute device 200 chip.

Each DDR memory subsystem 201 includes a number of memory controllers 202 and a physical layer 203. The PHY 203 defines a form factor or width 205 that ultimately defines the corresponding width of the DDR memory subsystem 201. In a case where the width 205 of the PHY 203 is characterized as occupying about one half of an edge 207 of the compute part 101, only two DDR subsystems 201 will fit on the edge 207 of the compute part 101.

With reference to compute device 200 of FIG. 2, only two edges 207 of the compute part 101 are available to DDR memory subsystems 201 after including the other components that demand locations next the compute part 101. Each of the available edges 207 can contain two memory subsystems 201 limiting the maximum number of memory modules available to the compute device 200 to four. Fewer memory modules result in less robust performance of the compute device 200. The compute device 200 can operate more effectively as additional memory is added. The ability to scale a compute device 200 to support more memory would result in improved performance and capabilities of the device. For example, a low number of DDR subsystems on the chip results in low overall data transfer rates.

An alternative is to use chiplets. A chiplet is a small integrated circuit (IC) that contains a well-defined subset of functionality. Chiplets are designed to be combined with other chiplets via an interposer in a single package to create a complex component. It is possible to design one chiplet for compute and another chiplet for DDR. The main disadvantage of this solution is the separation of functionality results in high latency between the compute and memory parts.

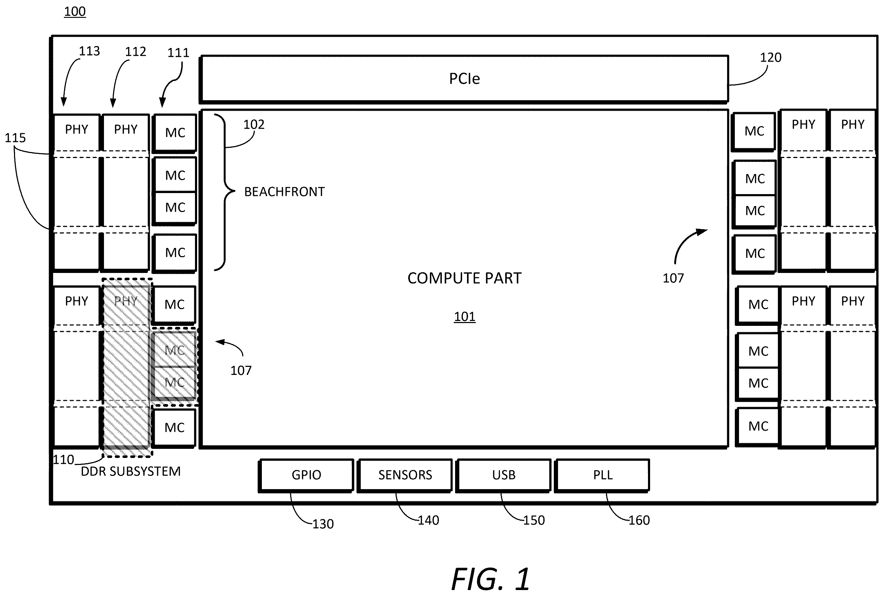

FIG. 1 is a plan view of a compute device 100 for providing scalable DDR memory subsystems according to aspects of the described technology. Processing for the compute device 100 occurs in the compute part 101. Compute part 101 may be a component such as a central processing unit (CPU) or a graphics processing unit (GPU) and the like. Various components of the compute system 100 require proximity to the compute part 101 in order to reduce the distance that signals and data travel from the compute part 101 to the component. For example, PCIe 120, GPIO 130, sensors 140, USB 150 and PLL 160 compete with DDR memory subsystems 110 for space near the edge of the compute part 101. In the compute device 100 of FIG. 1, there are two available edges 107 of the compute part 101 for locating DDR memory subsystems 110.

A DDR memory subsystem 110 may include a plurality of memory controllers 111 that are positioned between the compute part 101 and the physical layer(s) 112, 113 of the DDR memory subsystem. Each PHY 112, 113 is associated with a pair of MCs 111 from the plurality of memory controllers 111. In the group of chained PHY 112, 113, a first PHY 112 is positioned adjacent to the memory controllers 111 on one side. The compute part 101 is positioned adjacent to the memory controllers 111 on the opposite side of the memory controllers 111. The first PHY 112, located next to the memory controllers 111 is directly connected to its corresponding pair of memory controllers 111. This direct connection allows the first PHY 112 to communicate with its corresponding memory controllers 111 with minimal latency.

A second PHY 113 is placed next to the previous PHY (first PHY 112) one position distant from its corresponding pair of memory controllers 111. The first PHY 112 sits between the second PHY 113 and the memory controllers 111 creating a physical space between the second PHY 113 and the memory controllers 111. In order to allow communication between the second PHY 113 and its corresponding memory controllers 111, tunnels 115 are placed between the input and output pads of the PHY 112, 113. Memory controllers 111 communicate with distant PHYs, such as second PHY 113 via the tunnels 115. It will be noted that for each PHY 112 that lies between a chained PHY 113 and its memory controllers 111 that a distance equal to the span of one PHY is added to the communication length between memory controllers 111 and the distant PHY 113. As a consequence, a small amount of latency is experienced in a PHY 113 that is chained in a position that is not the first position adjacent to the memory controllers 111. While the example in FIG. 1 illustrates a chain of two PHYs 112, 113, it will be understood that any number of *n* PHYs may be chained together. Referring to the compute device 100 in FIG. 1, the first PHY 112 will experience no additional latency while the second PHY 113 will experience an additional latency proportional to one PHY span, representing the distance travelled across the first PHY 112. Where more than two PHYs are chained together, each subsequent PHY that is placed farther from the memory controllers 111 will add the latency of the distance added by the prior chained PHY. That is, as additional PHYs are added, the latency added by each additional PHY is cumulative for the added PHY.

Despite the nominal amount of latency added by chaining together PHYs 112, 113, the benefit of enabling more DDR subsystems 110 on a chip far outweighs the added inconvenience of a small amount of added latency. The density of the throughput achievable for a given expanse of edge space on a chip is referred to as beachfront 102. Due to the space needed for input/output pads on the PHY 112, 113, the DDR memory subsystem 110 takes up one unit of beachfront 102. The compute part 101 of compute device 100, only provides two beachfronts per edge 107 provided for DDR memory subsystems 110. Conventionally, this would establish a constraint that only two DDR subsystems 110 could be placed per edge 107 of the compute part 101. However, for the beachfront 102 associated with compute part 101 two PHY 112, 113 and their associated DDR memory subsystems can fit within one beachfront 102 with respect to the compute part 101. As the tunnels 115 are extendable to allow scaling of any number of PHYs to be linked, increased numbers of PHYs can be placed on a chip while only consuming one beachfront 102 along the edge 107 of compute part 101. Accordingly, the performance and data throughput of computing device 100 can be increased and performance improved.

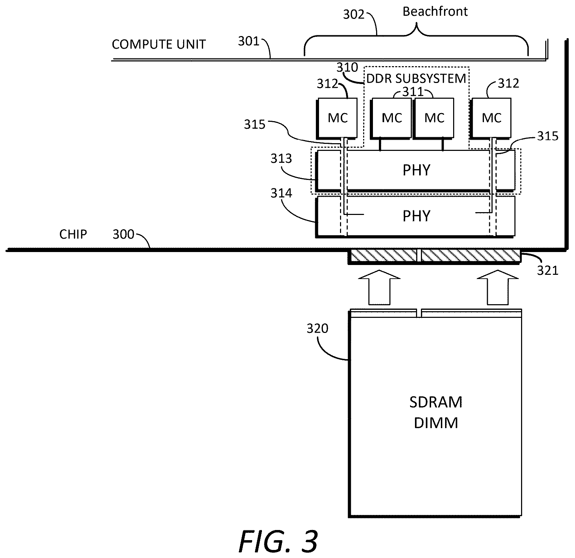

FIG. 3 is a plan view of a DDR memory subsystem and external memory according to aspects of the described technology. The compute device shown in FIG. 3 is implemented on a chip 300. Chip 300 may be designed as an application specific integrated circuit (ASIC) and can include a system on chip (SoC). The compute device uses memory to store and process data through a processing device such as compute part 301. The compute part 301 can be any type of device for processing data, such as a microcontroller, a central processing unit (CPU), graphics processing unit (GPU), or similarly capable devices. Compute part 301 provides data and processing commands to one or more memory controllers 311, 312. The memory controllers 311, 312 then manage data transfer in and out of memory. For example, memory may be implemented as a memory module such as an SRAM DIMM 320. SRAM DIMM 320 may have a variety of form factors based on the implementation. For example, the SRAM DIMM 320 may be a dual inline memory module (DIMM), or a small outline DIMM (SO-DIMM). Memory modules may include other configurations dependent on their implementation. The compute device includes a slot 321 that acts as the interface between an external memory source like SDRAM DIMM 320 and the compute device on chip 300. To enable the communication of the memory hardware with the memory controllers 312 of the compute device, a physical layer or PHY 313, 314 provides input and output contacts with SDRAM DIMM 320 along with other functionality such as clock circuits for managing the flow of data in and out of memory according to the processing instructions received by the memory controller 311, 312 from the compute part 301.

A corresponding memory slot 321 is provided in communication with each DDR memory subsystem 310 residing on the chip 300. A memory subsystem 310 includes a PHY 313, 314 and a corresponding number of memory controllers 311, 312. For instance, PHY 313 is positioned adjacent to memory controllers 311 and is directly connected to memory controllers 311. PHY 314 is chained to PHY 313 and associated with memory controllers 312. In the case of PHY 314, PHY 314 is separated from its memory controllers 312 by PHY 313, which is adjacent to all memory controllers serving a given beachfront 302. The memory controllers 312 corresponding to PHY 314 communicate with PHY 314 via tunnels 315 that extend across intervening PHY 313.

Compute part 301 accesses external memory, such as SDRAM DIMM 320 via DDR memory subsystem 310, which provides management of tasks and memory contents using memory controllers 311 and providing a physical interface between hardware and processing via PHY 314. The more memory that is available to the device, the more data throughput can be achieved. As space on the chip 300 is a limiting factor in the amount of memory that can be provided, a stacked or chained implementation of multiply PHY 313, 314 that can be implemented within the beachfront 302 distance of a single DDR memory subsystem 310 provides the opportunity to increase the amount of memory available to the system.

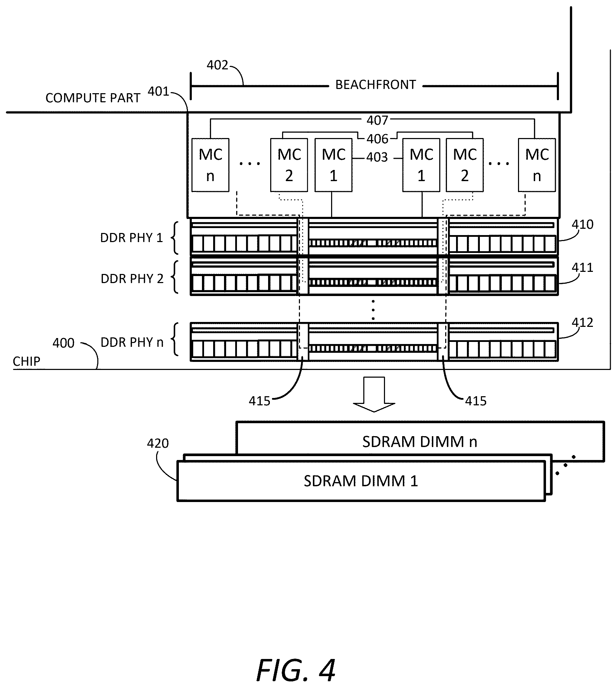

FIG. 4 is a plan view of a compute device having scalable memory capacity using linked PHYs according to aspects of the described technology. A compute device is implemented on chip 400 and includes a processing component or compute part 401. The compute part 401 processes data stored in memory 420. Memory 420 may be external to chip 400, such as in a SDRAM DIMM. Compute part 401 accesses memory 420 via a DDR memory subsystem that includes a memory controller and a physical layer. Memory controller manages the processing commands issued by the compute part 401 and the accessing memory 420 through the physical layer. The PHY provides an interface between hardware in the form of the SDRAM DIMM and the processing portions of the system.

A DDR memory subsystem contains a PHY that is associated with a pair of memory controllers for that PHY. Referring to FIG. 4, DDR PHY 1 410 is associated with pair of MCs 403. Similarly, DDR PHY 2 411 is associated with pair of MCs 406. The number of DDR memory subsystems is scalable to a number, n DDR memory subsystems. Each additional DDR memory subsystem will be associated with another pair of MCs up to DDR PHYn 412 and its associated pair of MCs 407.

Conventionally, the amount of memory that can be provided to a compute device is limited by the amount of area available at the edge of the compute part 401 of the device. Various components of the system require placement close to the compute part 401 to minimize the effect of latency. With respect to memory subsystems, the dimensions of the memory subsystem are controlled by the needs of the physical layer. The PHY includes many input and output pads that must be arranged carefully as they share communication channels and clock signals. This results in a form factor having a particular width. It is the width of the PHY that will limit the number of memory subsystems that can be accommodated within the available span of edge space alongside the compute part 401.

The span of edge space alongside the compute part 401 that abuts the memory subsystem is referred to as beachfront 402. Beachfront 402 represents the density of data transfer for a given span of chip edge. In the scalable memory compute device in FIG. 4, any number of memory subsystems can be provided by chaining together a number of PHYs extending one over another to produce a stack of PHYs that occupy the width of a single PHY. Memory controllers 403, 406, 407 are disposed between the stack of PHYs and the compute part 401 within a single beachfront 402. The beachfront 402 required is necessitated by the required width of the PHY, the number of memory controllers needed will not alter the beachfront required. All memory controllers are placed between the stacked PHYs and the compute part 401. Accordingly, all memory controllers are proximal to the compute part 401.

A pair of memory controllers can be allocated for each PHY in the stack of chained PHYs. A first PHY in the stack of PHYs is located beside the memory controllers, opposite the compute part 401. The first PHY is directly connected to its corresponding pair of memory controllers. The remaining PHYs in the stack of PHYs are physically separated from the memory controllers by a number of intervening PHYs. Each pair of memory controllers communicate with their associated PHY through tunnels 415 extending across the intervening PHYs. Each subsequent PHY that extends farther from the memory controllers adds a unit distance equal to the extent of the intervening PHYs. The added distance will contribute a nominal amount of latency to each linked PHY which accumulates according to the position of the PHY in the stack. For instance, the latency associated with PHY n 412 can be calculated as the unit latency of one PHY span multiplied by n-1, the number of intervening PHYs in the stack.

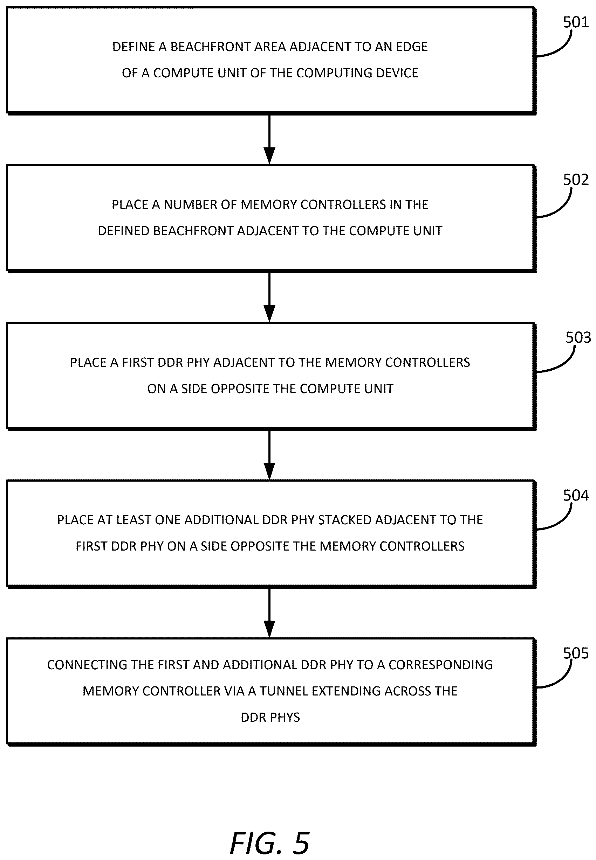

FIG. 5 is a process flow diagram for a method of scaling memory capacity in compute devices according to aspects of the described technology. At block 501 a beachfront is identified along an edge of the compute part of a computing device for placing one or more memory subsystems. At block 502, adjacent to the compute part, a number of memory controllers for supporting on or more PHY are placed. A first DDR PHY is placed next to the memory controllers on a side opposite the control part at block 503. At block 504, additional PHY are stacked one over another extending from the first PHY. At block 505, the stacked PHYs are connected to their corresponding memory controller via tunnels extending through intervening PHYs in the stack of PHYs.

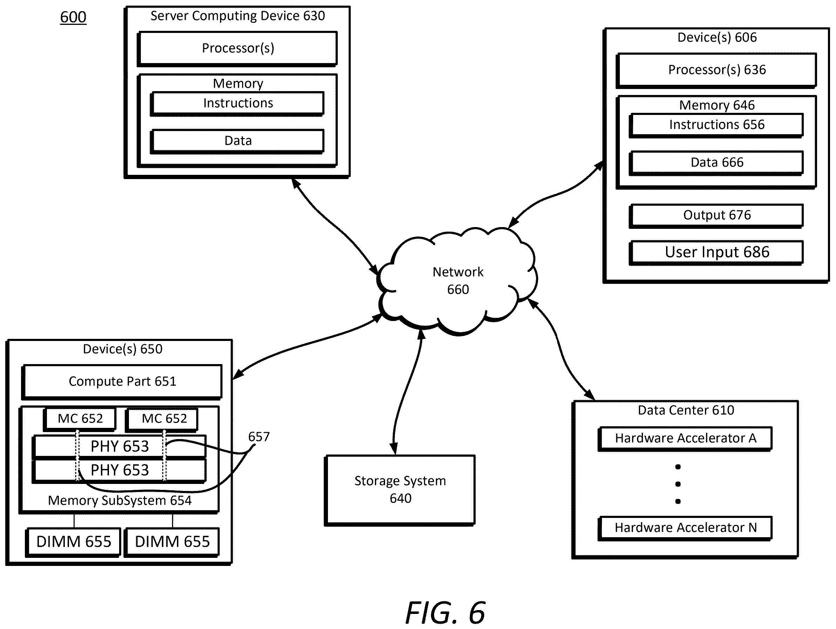

FIG. 6 illustrates an example system 600 including compute devices in which the features described above may be implemented. It should not be considered limiting the scope of the disclosure or usefulness of the features described herein. In this example, system 600 may include device(s) 606, server computing device 630, storage system 640, and network 660.

Each device 606 may be a personal computing device intended for use by a respective user. The device 606 may include one or more processors 636, memory 646, data 666 and instructions 656. Each device 606 may also include an output 676, user input 666, and location sensor 696. By way of example only, devices 606 may be mobile phones or devices such as a wireless-enabled PDA, smartphones, a tablet PC, a wearable computing device (e.g., a smartwatch, AR/VR headset, smart helmet, etc.), a netbook that is capable of obtaining information via the Internet or other networks, or a smart home device, such as a home assistant, smart thermostat, smart doorbell, smart light, etc.

Memory 646 of device 606 may store information that is accessible by processor 636. Memory 646 may also include data that can be retrieved, manipulated or stored by the processor 636. The memory 646 may be of any non-transitory type capable of storing information accessible by the processor 636, including a non-transitory computer-readable medium, or other medium that stores data that may be read with the aid of an electronic device, such as a hard-drive, memory card, read-only memory ("ROM"), random access memory ("RAM"), optical disks, as well as other write-capable and read-only memories. Memory 646 may store information that is accessible by the processors 636, including instructions 656 that may be executed by processors 636, and data 666.

Data 666 may be retrieved, stored or modified by processors 636 in accordance with instructions 656. For instance, although the present disclosure is not limited by a particular data structure, the data 666 may be stored in computer registers, in a relational database as a table having a plurality of different fields and records, XML documents, or flat files. The data 666 may also be formatted in a computer-readable format such as, but not limited to, binary values, ASCII or Unicode. By further way of example only, the data 666 may comprise information sufficient to identify the relevant information, such as numbers, descriptive text, proprietary codes, pointers, references to data stored in other memories including other network locations or information that is used by a function to calculate the relevant data.

The instructions 656 can be any set of instructions to be executed directly, such as machine code, or indirectly, such as scripts, by the processor 636. In that regard, the terms "instructions," "application," "steps," and "programs" can be used interchangeably herein. The instructions can be stored in object code format for direct processing by the processor, or in any other computing device language including scripts or collections of independent source code modules that are interpreted on demand or compiled in advance. Functions, methods and routines of the instructions are explained in more detail below.

The one or more processors 636 may include any conventional processors, such as a commercially available CPU or microprocessor. Alternatively, the processor can be a dedicated component such as an ASIC or other hardware-based processor. Although not necessary, computing devices 606 may include specialized hardware components to perform specific computing functions faster or more efficiently.

Device 650 processes data through a processor or compute part 651. Compute part 651 processes data and interacts with various components and subsystems of the device 650. For example, a memory subsystem 654 includes a number of memory controllers 652 and one or more physical layers (PHY) 653. Memory controllers 652 receive instructions from compute part 651 and controls and manages the reading and writing of data stored in memory, such as DDR DRAM DIMMs 655. Data is transferred from the physical memory DIMM 655 the processing components of device 650 across PHY 653. Multiple PHY 653 may be aligned beside each other and stacked with respect to the memory controllers 652. Memory controllers 652 are positioned adjacent to the compute part 651 to reduce latency. The beachfront used by the memory subsystem 654 is defined by the cross dimension of the PHY 653. Multiple PHY 653 may be supported from a single beachfront by stacking the PHY 653. Each stacked PHY 653 is supported by associated MCs 652. PHYs placed distant from the region containing the MCs 652 communicate with their associated MCs 652 through tunnels 657 extending across the PHYs 653.

Although Figure 6 functionally illustrates the processor, memory, and other elements of devices 606 as being within the same respective blocks, it will be understood by those of ordinary skill in the art that the processor or memory may actually include multiple processors or memories that may or may not be stored within the same physical housing. Similarly, the memory may be a hard drive or other storage media located in a housing different from that of the devices 606. Accordingly, references to a processor or device will be understood to include references to a collection of processors, devices, or memories that may or may not operate in parallel.

Output 676 may be a display, such as a monitor having a screen, a touchscreen, a projector, or a television. The display 676 of the one or more computing devices 606 may electronically display information to a user via a graphical user interface ("GUI") or other types of user interfaces. For example, as will be discussed below, display 676 may electronically display query results.

The user input 666 may be a mouse, keyboard, touch-screen, microphone, or any other type of input.

The devices 606 can be at various nodes of a network 660 and capable of directly and indirectly communicating with other nodes of network 660. Although one device is depicted in Figure 6, it should be appreciated that a typical system can include one or more devices, with each device being at a different node of network 660. The network 660 and intervening nodes described herein can be interconnected using various protocols and systems, such that the network can be part of the Internet, World Wide Web, specific intranets, wide area networks, or local networks. The network 660 can utilize standard communications protocols, such as WiFi, Bluetooth, 4G, 5G, etc., that are proprietary to one or more companies. Although certain advantages are obtained when information is transmitted or received as noted above, other aspects of the subject matter described herein are not limited to any particular manner of transmission.

In one example, system 600 may include one or more server computing devices 630 having a plurality of computing devices, e.g., a load balanced server farm, that exchange information with different nodes of a network for the purpose of receiving, processing and transmitting the data to and from other computing devices. For instance, one or more server computing devices 630 may be a web server that is capable of communicating with the one or more client computing devices 606 via the network 660. In addition, server computing device 630 may use network 660 to transmit and present information to a user of one of the other computing devices 606.

Server computing device 630 may include one or more processors, memory, instructions, data, etc. These components operate in the same or similar fashion as those described above with respect to computing device 606.

According to some examples, the server computing device 630 may be connected over the network to a data center 610 housing any number of hardware accelerators. The data center 610 can be one of multiple data centers or other facilities in which various types of computing devices, such as hardware accelerators, are located. Computing resources housed in the data center can be specified for repeated results monitoring, including identifying repeated query results, or the like.

The server computing device 630 can be configured to receive queries from the client computing device 606 on computing resources in the data center 610. For example, the environment can be part of a computing platform configured to provide a variety of services to users, through various user interfaces and/or application programming interfaces (APIs) exposing the platform services. The variety of services can include identifying content responsive to the query, determining whether query results are repeated query results, or the like. The client computing device 606 can transmit input data associated with a query. The server computing device 630 can receive the input data and, in response, identify and provide for output query results. When identifying the query results, the server computing device 630 can generate a signature for the query results. The generated signature may be compared to other signatures associated with the query results and/or historical query signatures. Based on the comparison, the server computing device 630 can determine whether the query results are repeated query results. In examples where the query results are repeated query results, the server computing device 630 can enable one or more preventative measures.

As other examples of potential services provided by a platform implementing the environment, the server computing device can maintain a variety of models in accordance with different constraints available at the data center. For example, the server computing device can maintain different families for deploying models on various types of TPUs and/or GPUs housed in the data center or otherwise available for processing.

Aspects of this disclosure can be implemented in digital electronic circuitry, in tangibly embodied computer software or firmware, and/or in computer hardware, such as the structure disclosed herein, their structural equivalents, or combinations thereof. Aspects of this disclosure can further be implemented as one or more computer programs, such as one or more modules of computer program instructions encoded on a tangible non-transitory computer storage medium for execution by, or to control the operation of, one or more data processing apparatus. The computer storage medium can be a machine-readable storage device, a machine-readable storage substrate, a random or serial access memory device, or combinations thereof. The computer program instructions can be encoded on an artificially generated propagated signal, such as a machine-generated electrical, optical, or electromagnetic signal, which is generated to encode information for transmission to suitable receiver apparatus for execution by a data processing apparatus.

The term "configured" is used herein in connection with systems and computer program components. For a system of one or more computers to be configured to perform particular operations or actions means that the system has installed on its software, firmware, hardware, or a combination thereof that cause the system to perform the operations or actions. For one or more computer programs to be configured to perform particular operations or actions means that the one or more programs include instructions that, when executed by one or more data processing apparatus, cause the apparatus to perform the operations or actions.

The term "data processing apparatus" refers to data processing hardware and encompasses various apparatus, devices, and machines for processing data, including programmable processors, a computer, or combinations thereof. The data processing apparatus can include special purpose logic circuitry, such as a field programmable gate array (FPGA) or an application specific integrated circuit (ASIC). The data processing apparatus can include code that creates an execution environment for computer programs, such as code that constitutes processor firmware, a protocol stack, a database management system, an operating system, or combinations thereof.

The data processing apparatus can include special-purpose hardware accelerator units for implementing machine learning models to process common and compute-intensive parts of machine learning training or production, such as inference or workloads. Machine learning models can be implemented and deployed using one or more machine learning frameworks.

The term "computer program" refers to a program, software, a software application, an app, a module, a software module, a script, or code. The computer program can be written in any form of programming language, including compiled, interpreted, declarative, or procedural languages, or combinations thereof. The computer program can be deployed in any form, including as a stand-alone program or as a module, component, subroutine, or other unit suitable for use in a computing environment. The computer program can correspond to a file in a file system and can be stored in a portion of a file that holds other programs or data, such as one or more scripts stored in a markup language document, in a single file dedicated to the program in question, or in multiple coordinated files, such as files that store one or more modules, sub programs, or portions of code. The computer program can be executed on one computer or on multiple computers that are located at one site or distributed across multiple sites and interconnected by a data communication network.

The term "database" refers to any collection of data. The data can be unstructured or structured in any manner. The data can be stored on one or more storage devices in one or more locations. For example, an index database can include multiple collections of data, each of which may be organized and accessed differently.

The term "engine" refers to a software-based system, subsystem, or process that is programmed to perform one or more specific functions. The engine can be implemented as one or more software modules or components or can be installed on one or more computers in one or more locations. A particular engine can have one or more computers dedicated thereto, or multiple engines can be installed and running on the same computer or computers.

The processes and logic flows described herein can be performed by one or more computers executing one or more computer programs to perform functions by operating on input data and generating output data. The processes and logic flows can also be performed by special purpose logic circuitry, or by a combination of special purpose logic circuitry and one or more computers.

A computer or special purposes logic circuitry executing the one or more computer programs can include a central processing unit, including general or special purpose microprocessors, for performing or executing instructions and one or more memory devices for storing the instructions and data. The central processing unit can receive instructions and data from the one or more memory devices, such as read only memory, random access memory, or combinations thereof, and can perform or execute the instructions. The computer or special purpose logic circuitry can also include, or be operatively coupled to, one or more storage devices for storing data, such as magnetic, magneto optical disks, or optical disks, for receiving data from or transferring data to. The computer or special purpose logic circuitry can be embedded in another device, such as a mobile phone, a personal digital assistant (PDA), a mobile audio or video player, a game console, a Global Positioning System (GPS), or a portable storage device, e.g., a universal serial bus (USB) flash drive, as examples.

Computer readable media suitable for storing the one or more computer programs can include any form of volatile or non-volatile memory, media, or memory devices. Examples include semiconductor memory devices, e.g., EPROM, EEPROM, or flash memory devices, magnetic disks, e.g., internal hard disks or removable disks, magneto optical disks, CD-ROM disks, DVD-ROM disks, or combinations thereof.

Aspects of the disclosure can be implemented in a computing system that includes a back end component, e.g., as a data server, a middleware component, e.g., an application server, or a front end component, e.g., a client computer having a graphical user interface, a web browser, or an app, or any combination thereof. The components of the system can be interconnected by any form or medium of digital data communication, such as a communication network. Examples of communication networks include a local area network (LAN) and a wide area network (WAN), e.g., the Internet.

The computing system can include clients and servers. A client and server can be remote from each other and interact through a communication network. The relationship of client and server arises by virtue of the computer programs running on the respective computers and having a client-server relationship to each other. For example, a server can transmit data, e.g., an HTML page, to a client device, e.g., for purposes of displaying data to and receiving user input from a user interacting with the client device. Data generated at the client device, e.g., a result of the user interaction, can be received at the server from the client device.

Unless otherwise stated, the foregoing alternative examples are not mutually exclusive but may be implemented in various combinations to achieve unique advantages. As these and other variations and combinations of the features discussed above can be utilized without departing from the subject matter defined by the claims, the foregoing description of the examples should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many possible implementations. Further, the same reference numbers in different drawings can identify the same or similar elements.

## Claims

1. A compute device comprising:
a processor;
a plurality of memory channels in communication with the processor, each memory channel comprising:
a memory controller (MC) in communication with the processor; and
a physical layer (PHY) associated with the MC of the memory channel;
wherein a plurality of PHY layers for a plurality of the memory channels are stacked widthwise to produce a beachfront for the plurality of PHY layers that takes up a space of a single PHY at an edge of the processor.

2. The compute device of claim 1, wherein the compute device is configured as a system on chip (SoC) device.

3. The compute device of claim 1 or claim 2, wherein
the plurality of stacked memory channels extend from a length along an edge of the processor, the length defining the beachfront utilized by the plurality of stacked memory channels.

4. The compute device of one of the preceding claims, further comprising:
a tunnel extending from a MC of a memory channel to the PHY for that memory channel, the tunnel extending across a second PHY of another memory channel.

5. The compute device of claim 4, the tunnel extending between an input pad and an output pad of the second PHY of the other memory channel; or
the tunnel extending across a plurality of PHYs between the MC and PHY associated with the MC.

6. The compute device of one of the preceding claims, wherein each MC of the plurality of memory channels are positioned in close proximity to the processor.

7. The compute device of one of the preceding claims, further comprising:
a pair of memory controllers (MCs) associated with each PHY;
a first pair of memory controllers in direct contact with a first PHY of the stacked PHYs; and
a second pair of memory controllers connected to a second PHY of the stacked PHYs, the second pair of MCs connected to the second PHY by a tunnel.

8. The compute device of one of the preceding claims, further comprising:
a plurality of stacked PHYs, a first of the plurality of stacked PHYs positioned closest to the processor;
a plurality of memory controllers (MCs) between and adjacent to the first PHY and the processor;
at least one tunnel extending from the plurality of memory controllers to a second PHY of the plurality of stacked PHYs, the at least one tunnel connecting a pair of the plurality of MCs to the second PHY.

9. The compute device of claim 8, wherein the number of stacked PHYs is greater than two and wherein each of the stacked PHYs corresponds to a pair of MCs of the plurality of MCs; and
a tunnel corresponding to each PHY and the PHY's corresponding pair of MCs.

10. A method for providing dual data rate (DDR) memory to a compute device, comprising:
placing a plurality of memory controllers (MCs) adjacent to a processor of the device;
placing a first DDR physical layer (PHY) adjacent to the side of the plurality of MCs opposite the processor; and
stacking at least one additional DDR PHY next to the first DDR PHY opposite the plurality of MCs, the at least one additional DDR PHY connected to the plurality of MCs via a tunnel extending across the first DDR PHY and the at least one additional DDR PHY.

11. The method of claim 10, wherein the tunnel extends across the DDR PHY between a set of input pads and a set of output pads of the DDR PHY.

12. The method of claim 10 or claim 11, wherein the plurality of MCs comprises a pair of MCs corresponding to each of the first DDR PHY and the at least one additional DDR PHY.

13. The method of claim 12, comprising:
providing instructions from a pair of MCs to the corresponding DDR PHY through a tunnel extending from the pair of MCs to the corresponding DDR PHY.

14. The method of claim 12,
for each DDR PHY, providing a pair of tunnels a first tunnel extending from the DDR PHY to a first MC of the corresponding pair of MCs, and a second tunnel extending from the DDR PHY to a second MC of the corresponding pair of MCs.

15. The method of one of claims 10 to 14, further comprising:
directly connecting the first DDR PHY to the plurality of MCs; and/or
wherein the at least one tunnel is disposed in a gap between the input/output pads of the first DDR PHY and the at least one additional DDR PHY; and/or
wherein a number of additional DDR PHY is scalable to a number n DDR PHY, and/or
wherein processor comprises at least one of a central processing unit (CPU) and a graphics processing unit (GPU); and/or
wherein the computing system is implemented as a system on chip (SoC).
